# FASCICULE DE BREVET EUROPEEN

(11) **EP 2 240 954 B1**
(45) Date de publication et mention de la délivrance du brevet: **27.03.2013**
(21) Numéro de dépôt: 08873890.1
(22) Date de dépôt: 27.11.2008
(51) Int. Cl.: H01L 21/02, H01L 21/20, H01L 29/06, B82Y 10/00

(54) **PROCÉDÉ D'ÉLABORATION, SUR UN MATÉRIAU DIÉLECTRIQUE, DE NANOFILS EN MATÉRIAUX SEMI-CONDUCTEUR CONNECTANT DEUX ÉLECTRODES**
VERFAHREN ZUM WACHSTUM VON NANODRÄHTEN AUS HALBLEITERMATERIALIEN, DIE ZWEI ELEKTRODEN VERBINDEN, AUF EINEM DIELEKTRISCHEN MATERIAL
METHOD OF GROWING, ON A DIELECTRIC MATERIAL, NANOWIRES MADE OF SEMICONDUCTOR MATERIALS CONNECTING TWO ELECTRODES

(30) Priorité: 28.11.2007 FR 0708351
(43) Date de publication de la demande: 20.10.2010
(73) Titulaire: Commissariat à l'Énergie Atomique et aux Énergies Alternatives, 75015 Paris (FR); Centre National de la Recherche Scientifique - CNRS -, 75794 Paris Cedex 16 (FR)
(72) Inventeur: ERNST, Thomas, 38210 Morette (FR); BARON, Thierry, 38120 Saint Egreve (FR); FERRET, Pierre, 38000 Grenoble (FR); GENTILE, Pascal, 38500 Voiron (FR); SALEM, Bassem, 38360 Sassenage (FR)
(74) Mandataire: Hecké, Gérard
(86) Numéro de dépôt international: PCT/FR2008/001651
(87) Numéro de publication internationale: WO 2009/098398

(56) Documents cités:
- WO-A-2005/065425
- WO-A-2005/072089
- WO-A-2006/016914
- KR-A- 20020 093 270

## Description

### Domaine technique de l'invention

L'invention est relative à un procédé d'élaboration de nanofils connectant deux électrodes, les nanofils étant en matériau semi-conducteur monocristallin, le procédé comportant successivement sur une couche en matériau diélectrique :
- la formation des électrodes,
- la croissance des nanofils, au moyen d'un catalyseur, entre les électrodes, parallèlement à la couche en matériau diélectrique.

### État de la technique

L'amélioration continue des performances des circuits microélectroniques passe par une augmentation de la densité d'intégration des composants élémentaires des circuits. Jusqu'à présent, l'amélioration des performances a été réalisée par la miniaturisation continue des dimensions du transistor MOSFET. Les transistors sont maintenant de taille nanométrique et leur réalisation se heurte à de nombreuses difficultés technologiques. Les effets quantiques au sein du transistor à effet de champ ne sont plus négligeables et les matériaux classiques de la microélectronique ne sont plus aptes à fournir des caractéristiques en adéquation avec les spécifications demandées. Des solutions alternatives sont donc proposées afin de continuer à améliorer les performances de circuits microélectroniques.

Une des voies les plus prometteuses consiste à utiliser des nano-objets et plus précisément des nanofils semiconducteurs. Les nanofils peuvent être utilisés pour former des canaux monocristallins de transistors de type MOS à effet de champ.

Le document WO-A-2006/083310 décrit la réalisation de nanofils de silicium à partir d'un substrat de silicium sur isolant, par gravure par voie humide. Cette approche présente l'inconvénient, de nécessiter l'utilisation des procédés classiques de photolithographie pour définir les dimensions des nanofils et l'utilisation d'un substrat monocristallin de silicium pour obtenir des nanofils monocristallins. Dans cette approche, seule l'épaisseur peut être relativement bien définie car c'est l'épaisseur du substrat initial. La dispersion sur la largeur est plus importante car elle est liée aux dispersions des procédés de gravure et de lithographie utilisés.

Le brevet US 7208094B2 décrit la réalisation de ponts en silicium monocristallin entre deux électrodes en silicium. A partir d'un substrat de silicium sur isolant, deux électrodes en silicium sont formées de manière classique par photolithographie et gravure. Des agrégats de matériaux catalyseurs sont alors déposés sur une paroi verticale d'une des électrodes afin de permettre la croissance de nanofils de silicium horizontaux entre les parois verticales opposées des électrodes. Cette méthode nécessite la formation d'électrodes en silicium cristallin donc d'une base monocristalline initiale. Par ailleurs, les agrégats étant recuits, il en résulte une forte dispersion sur le diamètre des nanofils.

Ces deux approches sont incompatibles avec l'intégration industrielle de circuits comportant plusieurs niveaux de transistors les uns au-dessus des autres. En effet, la formation d'une seconde couche en silicium monocristallin nécessite l'utilisation de procédés technologiques de recristallisation ou de report de couches ayant des budgets thermiques qui peuvent être incompatibles avec les transistors formés sur une première couche en silicium. De plus, pour la réalisation d'un circuit , il est nécessaire que les transistors soient identiques. Or, les nanofils présentent, entre eux, une dispersion importante dans leurs dimensions (diamètre, largeur, épaisseur) ce qui rend impossible leur utilisation dans un circuit semi-conducteur.

KR 2002-0093270 décrit un procédé de réalisation de nanotubes de carbone par croissance sélective entre deux électrodes.

### Objet de l'invention

L'invention a pour objet un procédé de réalisation de nanofils en matériau semi-conducteur de diamètre parfaitement défini, reproductible, ce procédé étant facile à mettre en oeuvre et ayant un budget thermique limité.

Selon l'invention, ce but est atteint par les revendications annexées et plus particulièrement par le fait que les électrodes étant en matériau métallique, le catalyseur est constitué par une couche inférieure d'au moins une des électrodes, ladite couche inférieure étant directement en contact avec la couche en matériau diélectrique, de manière à ce que les nanofils formés soient en contact avec la couche en matériau diélectrique, le nanofil ayant un diamètre désiré égal à une épaisseur du catalyseur.

### Description sommaire des dessins

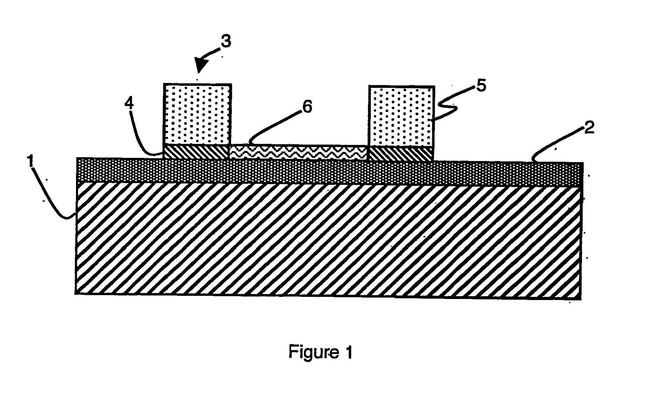

D'autres avantages et caractéristiques ressortiront plus clairement de la description qui va suivre d'un mode particulier de réalisation de l'invention donné à titre d'exemple non limitatif et représenté schématiquement, en coupe, à la figure 1 (figure unique).

### Description d'un mode de réalisation préférentiel de l'invention

Comme illustré sur la figure 1, deux électrodes 3 en matériau métallique sont formées sur une couche en matériau diélectrique 2 d'un substrat 1. Les électrodes 3 présentent perpendiculairement au substrat 1, des faces latérales opposées, sensiblement parallèles (verticales sur la figure 1), entre lesquelles doivent être formés les nanofils.

La couche en matériau diélectrique 2 est, par exemple, choisie parmi les matériaux à base d'oxyde de silicium, les matériaux à base de nitrure de silicium, les matériaux à base de HfO₂ et les matériaux à base de Al₂O₃. Le substrat 1 est par exemple en silicium massif, mais il peut être en verre ou dans tout autre matériau pouvant supporter les étapes technologiques ultérieures. Si le substrat 1 est en matériau diélectrique, la couche 2 peut être intégrée dans le substrat 1. Le substrat 1 peut, par exemple, comporter des transistors formant des circuits intégrés encapsulés dans la couche en matériau diélectrique 2.

Une couche en matériau catalyseur 4, en contact avec la couche en matériau diélectrique 2, est constituée par une couche inférieure d'au moins une des deux électrodes 3. La couche de catalyseur 4 est en matériau métallique, par exemple, choisi parmi Au, Al, Fe, Ti, PtSi, NiSi, Cu. Les électrodes 3 comportent avantageusement chacune une couche de contact 5, qui surmonte la couche inférieure en matériau catalyseur 4. La couche de contact 5 et la couche de catalyseur 4 sont réalisées dans des matériaux différents. La couche de contact 5 est de préférence en aluminium ou en cuivre.

La couche de catalyseur 4 peut être déposée par toute technique adaptée, par exemple, par pulvérisation cathodique, évaporation ou dépôt chimique en phase vapeur. La localisation de la couche de catalyseur 4 peut être réalisée en même temps que la formation des électrodes ou après la formation des électrodes 3, par exemple, par photolithographie et gravure ou par décollement (« lift-off » en anglais).

De manière classique, une couche de masquage (non représentée) peut être utilisée pour délimiter les électrodes 3, notamment les faces latérales opposées de leurs couches inférieures 4.

La croissance des nanofils 6 est alors réalisée à partir du catalyseur 4 d'au moins une des électrodes 3, parallèlement à la couche en matériau diélectrique 2. La croissance des nanofils 6 monocristallins et en matériau semi-conducteur est réalisée, de manière classique, par toute technique adaptée, par exemple par dépôt chimique en phase vapeur, épitaxie par jet moléculaire, jusqu'à ce qu'ils connectent à leur partie inférieure les faces opposées des deux électrodes 3. La couche inférieure en matériau catalyseur 4 étant en contact direct avec la couche en matériau diélectrique 2, les nanofils 6 ainsi formés sont en contact avec la couche en matériau diélectrique 2.

La présence de la couche en matériau diélectrique 2 au contact de la couche en matériau catalyseur 4 fait que le nanofil 6, lors de sa croissance, reste en contact avec la couche en matériau diélectrique 2. Ainsi, la croissance du nanofil est sensiblement horizontale sur la figure 1 au lieu d'avoir une croissance quasi-verticale comme dans les procédés selon l'art antérieur. Cet inconvénient avait été contourné dans le brevet US7208094, en imposant à partir des électrodes en silicium cristallin, la structure cristalline des nanofils 6.

L'épaisseur et la largeur des nanofils 6 sont liées à l'épaisseur et la largeur de la couche de catalyseur 4, les nanofils 6 sont des cylindres dont le diamètre est égal à l'épaisseur de la couche en matériau catalyseur 4. Par ailleurs, pour former deux nanofils 6, il n'est pas nécessaire d'avoir sur une même électrode 3 deux surfaces libres en matériau catalyseur séparées par une surface non réactive. La largeur de la couche de catalyseur 4 contrôle le nombre de nanofils 6 réalisé entre les électrodes. Il est alors possible de faire croître un nanofil 6 ou plus en modulant simplement la surface en regard des électrodes. Le diamètre des nanofils 6 étant égale à l'épaisseur du matériau catalyseur 4, la dispersion sur le diamètre des nanofils est directement liée à la dispersion sur l'épaisseur du matériau catalyseur. Les procédés de dépôt étant très reproductibles sur plusieurs substrats et ayant une faible dispersion sur un même substrat, il y a une grande maîtrise du diamètre désiré des nanofils. Ce mode de réalisation est particulièrement avantageux pour sa mise en oeuvre car le diamètre des nanofils en matériau semi-conducteur est directement lié à l'épaisseur du matériau catalyseur. Cet avantage ne peut pas être obtenu avec des nanotubes de carbones car ils présentent une forte dispersion dans leurs diamètres. En effet, lors de la croissance, leur diamètre est décorrélé de l'épaisseur de leur matériau catalyseur de départ.

L'article de M. Zacharias et al. « Semiconducttor Nanowires : From Self-Organization to Patterned Growth » Small Journal 2006, 2, No. 6, pp700-717 décrit différents matériaux pouvant être utilisés pour la croissance des nanofils et les techniques correspondantes.

De préférence, les nanofils 6 sont en silicium, en germanium ou en un alliage de ces matériaux. Si les nanofils sont en silicium, leur croissance est préférentiellement réalisée par dépôt chimique en phase vapeur, par exemple, à une température de 400°C, sous une pression de 20 mPa et avec des débits de silane (SiH₄) et d'hydrogène (H₂) respectivement de 50 sccm (centimètre cube standard par minute) et de 3,7 slm (litre standard par minute).

A titre d'exemple, avec un matériau catalyseur 4 en or ayant une épaisseur égale à 20nm, la croissance de nanofils de silicium est réalisée par dépôt chimique en phase vapeur, à une température de 450°C, sous une pression de 20 mPa et avec des débits de silane (SiH₄) et d'hydrogène (H₂) respectivement de 50 sccm (centimètre cube standard par minute) et de 3,7 slm (litre standard par minute). Les nanofils ont au final une épaisseur égale à 20nm.

Des nanofils 6 en matériau semi-conducteur non intentionnellement dopé peuvent être réalisés. Ces nanofils peuvent, par la suite, être dopés par les techniques d'implantations classiques. Cependant, il est également possible en modifiant les conditions de croissance, de former des nanofils 6 dopés de type p ou de type n et des nanofils présentant un type de dopage puis l'autre voire une alternance de ces dopages sur un même nanofil 6.

Différentes architectures d'électrodes 3 sont possibles. La croissance des nanofils 6 peut être réalisée à partir d'une seule face latérale de l'électrode 3. Cependant, elle peut être réalisée à partir de plusieurs faces latérales libres d'une électrode 3 afin de connecter cette électrode 3 à une pluralité d'autres électrodes.

Il est alors possible dans une variante de réalisation de former plus de deux électrodes, par exemple 3 électrodes qui sont reliées entre elles, par des nanofils 6, selon un schéma prédéfini. La croissance des nanofils 6 peut être réalisée à partir de plusieurs faces latérales d'une des électrodes 3, respectivement opposées à une face d'une autre électrode.

Le procédé d'élaboration de nanofils 6 décrit ci-dessus peut avantageusement être utilisé pour la réalisation de transistors à effet de champ, dans lesquels les électrodes 3 constituent les électrodes de source et de drain, le nanofil 6 formant le canal du transistor sur la couche de matériau isolant 2. L'électrode de grille est réalisée de manière classique par la suite au-dessus du canal constitué par le nanofil 6. Ainsi, il est possible de réaliser, sur un isolant, des transistors ayant un canal en matériau semi-conducteur monocristallin obtenu par croissance localisée directe et sans contact cristallin continu avec un substrat cristallin ou sans utilisation de report de couche cristalline.

Il est alors possible de réaliser des transistors, des architectures logiques ou des mémoires volatiles ou non, au-dessus d'une structure contenant déjà des transistors qui ont été encapsulés par une couche en matériau diélectrique. Cette technique est alors particulièrement avantageuse pour réaliser des architectures dites 3D comprenant plusieurs niveaux de transistors disposés les uns au-dessus des autres et classiquement séparés par une couche en matériau diélectrique.

## Revendications

1. Procédé d'élaboration de nanofils (6) connectant deux électrodes (3), les nanofils (6) étant en matériau semi-conducteur monocristallin, le procédé comportant successivement sur une couche en matériau diélectrique (2) :
- la formation des électrodes (3),
- la croissance des nanofils (6), au moyen d'un catalyseur (4), entre les électrodes (3), parallèlement à la couche en matériau diélectrique (2),
procédé **caractérisé en ce que** les électrodes (3) étant en matériau métallique, le catalyseur (4) est constitué par une couche inférieure d'au moins une des électrodes (3), ladite couche inférieure étant directement en contact avec la couche en matériau diélectrique (2), de manière à ce que les nanofils (6) formés soient en contact avec la couche en matériau diélectrique (2), le nanofil ayant un diamètre désiré égal à l'épaisseur du catalyseur.

2. Procédé selon la revendication 1, **caractérisé en ce que** l'électrode (3) comporte une couche de contact (5) surmontant la couche inférieure en matériau catalyseur (4).

3. Procédé selon l'une des revendications 1 et 2, **caractérisé en ce que** le matériau catalyseur est choisi parmi Au, Al, Fe, Ti, PtSi, NiSi, Cu.

4. Procédé selon l'une des revendications 2 et 3, **caractérisé en ce que** la couche inférieure en matériau catalyseur (4) et la couche de contact (5) sont réalisées dans des matériaux différents.

5. Procédé selon la revendication 4, **caractérisé en ce que** la couche de contact (5) est en aluminium ou en cuivre.

6. Procédé selon l'une quelconque des revendications 1 à 5, **caractérisé en ce que** la couche en matériau diélectrique (2) est choisie parmi les matériaux à base d'oxyde de silicium, les matériaux à base de nitrure de silicium, les matériaux à base de HfO₂ et les matériaux à base de Al₂O₃.

7. Procédé selon l'une quelconque des revendications 1 à 6, **caractérisé en ce que** les nanofils (6) sont en silicium.

## Claims

1. Method for fabricating nanowires (6) connecting two electrodes (3), the nanowires (6) being made from single-crystal semi-conductor material, the method successively comprising on a layer of dielectric material (2):
- forming the electrodes (3),
- growing the nanowires (6) by means of a catalyst (4) between the electrodes (3), parallel to the layer of dielectric material (2),
method **characterized in that** the electrodes (3) being made from metallic material, the catalyst (4) is formed by a bottom layer of at least one of the electrodes (3), said bottom layer being directly in contact with the layer of dielectric material (2) so that the formed nanowires (6) are in contact with the layer of dielectric material (2), the nanowire having a required diameter equal to the thickness of the catalyst.

2. Method according to claim 1, **characterized in that** the electrode (3) comprises a contact layer (5) above the bottom layer of catalyst material (4).

3. Method according to one of claims 1 and 2, **characterized in that** the catalyst material is chosen from Au, Al, Fe, Ti, PtSi, NiSi or Cu.

4. Method according to one of claims 2 and 3, **characterized in that** the bottom layer of catalyst material (4) and the contact layer (5) are made from different materials.

5. Method according to claim 4, **characterized in that** the contact layer (5) is made from aluminum or copper.

6. Method according to any one of claims 1 to 5, **characterized in that** the layer of dielectric material (2) is chosen from silicon oxide-based materials, silicon nitride-based materials, HfO₂-based materials and Al₂O₃-based materials.

7. Method according to any one of claims 1 to 6, **characterized in that** the nanowires (6) are made from silicon.

## Patentansprüche

1. Verfahren zur Herstellung von Nanodrähten (6), die zwei Elektroden (3) verbinden, wobei die Nanodrähte (6) aus monokristallinem Halbleitermaterial bestehen, wobei das Verfahren auf einer Schicht aus dielektrischem Material (2) nacheinander umfasst:
das Ausbilden der Elektroden (3),
-das Aufwachsen der Nanodrähte (6) mittels eines Katalysators (4) zwischen den Elektroden (3), parallel zu der Schicht aus dielektrischem Material (2),
Verfahren, welches **dadurch gekennzeichnet ist, dass** - da die Elektroden (3) aus metallischem Material bestehen - der Katalysator (4) durch eine untere Schicht von wenigstens einer der Elektroden (3) gebildet ist, wobei die untere Schicht direkt mit der Schicht aus dielektrischem Material (2) in Kontakt ist, so dass die gebildeten Nanodrähte (6) mit der Schicht aus dielektrischem Material (2) in Kontakt sind, wobei der Nanodraht einen gewünschten Durchmesser, der gleich der Dicke des Katalysators ist, aufweist.

2. Verfahren nach Anspruch 1, **dadurch gekennzeichnet, dass** die Elektrode (3) eine auf der unteren Schicht aus Katalysatormaterial (4) angeordnete Kontaktschicht (5) umfasst.

3. Verfahren nach einem der Ansprüche 1 und 2, **dadurch gekennzeichnet, dass** das Katalysatormaterial aus Au, Al, Fe, Ti, PtSi, NiSi, Cu ausgewählt ist.

4. Verfahren nach einem der Ansprüche 2 und 3, **dadurch gekennzeichnet, dass** die untere Schicht aus Katalysatormaterial (4) und die Kontaktschicht (5) aus unterschiedlichen Materialien ausgebildet sind.

5. Verfahren nach Anspruch 4, **dadurch gekennzeichnet, dass** die Kontaktschicht (5) aus Aluminium oder aus Kupfer besteht.

6. Verfahren nach einem der Ansprüche 1 bis 5, **dadurch gekennzeichnet, dass** die Schicht aus dielektrischem Material (2) aus den Materialien auf der Basis von Siliziumoxid, den Materialien auf der Basis von Siliziumnitrid, den Materialien auf der Basis von HfO₂ und den Materialien auf der Basis von Al₂O₃ ausgewählt ist.

7. Verfahren nach einem der Ansprüche 1 bis 6, **dadurch gekennzeichnet, dass** die Nanodrähte (6) aus Silizium bestehen.
